# EUROPEAN PATENT SPECIFICATION

(11) **EP 2 616 566 B1**
(45) Date of publication and mention of the grant of the patent: **11.04.2018**
(21) Application number: 11726528.0
(22) Date of filing: 01.06.2011
(51) Int. Cl.: C23C 14/35, H01J 37/34, C03C 17/00

(54) **IMPROVED METHOD OF CO-SPUTTERING ALLOYS AND COMPOUNDS USING A DUAL C-MAG CATHODE ARRANGEMENT AND CORRESPONDING APPARATUS**
VERBESSERTES VERFAHREN ZUM CO-SPUTTERN VON LEGIERUNGEN UND VERBINDUNGEN MIT EINER DOPPELTEN C-MAG-KATHODENANORDNUNG UND ENTSPRECHENDE VORRICHTUNG
PROCÉDÉ AMÉLIORÉ DE CO-PULVÉRISATION CATHODIQUE D'ALLIAGES ET DE COMPOSÉS À L'AIDE D'AGENCEMENT DE CATHODE C-MAG DOUBLE ET APPAREIL CORRESPONDANT

(30) Priority: 17.09.2010 US 923389
(43) Date of publication of application: 24.07.2013
(73) Proprietor: Guardian Europe S.à.r.l., 8070 Bertrange (LU); Guardian Glass, LLC, Auburn Hills MI 48326 (US)
(72) Inventor: DIETRICH, Anton, CH-9476 Fontnas (CH); O'CONNOR, Kevin, Lasalle ON N9J0A9 (CA); BLACKER, Richard, Farmington Hills MI 48334 (US)
(74) Representative: Hess, Peter K. G.
(86) International application number: PCT/US2011/000982
(87) International publication number: WO 2012/036718

(56) References cited:
- WO-A1-92/01081
- WO-A2-2006/076345
- DE-A1-102008 034 960
- US-A1- 2008 289 957

## Description

### BACKGROUND OF THE INVENTION

Films made from alloys and compounds including several components sometimes will have desirable properties. These properties may lead to improved mechanical and/or chemical durability of a deposited layer stack. Unfortunately, in some cases, manufacturing single sputtering targets that can be used in large-scale manufacturing to produce films of the appropriate composition may be technically challenging, and even cost-prohibitive.

Co-sputtering is a known method that can bypass these issues by sputtering from two targets simultaneously during film deposition. However, in certain instances, the conventional methods can produce a significantly graded layer with a strongly varying composition from the bottom to the top of the layer, rather than a true or substantial mixture of the two materials. To improve that, a larger target-to-substrate distance would be required. However, this would require a specially designed deposition chamber and may lead to a more porous film due to the larger target-to-substrate distance.

Document Wo 92/01081 describes a method and an apparatus for depositing thin homogeneous films by dual target reactive sputtering, wherein composition and quality of the sputtered coating can be adjusted or influenced by different cathode potentials provided to each target as well as the rotatable position
of the magnets, the speed of rotation of each target and of course the base materials of the targets.

However, it will be seen that there is a need in the art for an improved method and/or apparatus for sputtering alloys and/or compounds that will result in a true mixture of materials.

### BRIEF SUMMARY OF THE INVENTION

In certain example embodiments of this invention, there is provided a method of making a coated article comprising a film supported by a substrate, the method comprising: having first and second rotating cylindrical sputtering targets, the first sputtering target comprising a first sputtering material and the second sputtering target comprising a second sputtering material, and sputtering the first and second sputtering targets, and wherein at least one magnet bar of the second sputtering target is oriented so that during the sputtering of the second target second sputtering material from the second target is sputtered onto the first target, and during the sputtering of the first target the first sputtering material of the first target and second sputtering material which was sputtered onto the first target from the second target is sputter-deposited onto a substrate to form the film. The substrate may be a glass substrate in certain example embodiments.

The sputter-deposited film may be substantially transparent, may be dielectric or conductive, and may be part of a low-E coating for a window, or may be a transparent conductive oxide (TCO) film in certain example instances.

In certain example embodiments, there is provided a sputtering apparatus for sputter-depositing a film on a substrate, the apparatus comprising: first and second adjacent sputtering targets with no other sputtering targets between the first and second sputtering targets, wherein at least one magnet of the second sputtering target is oriented so that during sputtering of the second target second sputtering material from the second target is sputtered toward the first target, and during sputtering of the first target first sputtering material of the first target and second sputtering material which was sputtered onto the first target from the second target is sputtered toward the substrate to form the film; and wherein a plasma erosion zone of the first target is oriented so as to generally face a first direction which is substantially normal to the substrate, and a plasma erosion zone of the second target is oriented to generally face a second direction that is substantially toward the first target and is angled from about 70-170 degrees from the first direction.

### BRIEF DESCRIPTION OF THE DRAWINGS

FIG. 1 is a cross-sectional schematic view of a sputtering apparatus containing dual C-MAG sputtering targets according to certain example embodiments of this invention.
FIG. 2 is a cross-sectional schematic view of a sputtering apparatus containing dual C-MAG sputtering targets according to another example embodiment of this invention, and includes an optional shield and optional gas inlets.

### DETAILED DESCRIPTION OF EXAMPLE EMBODIMENTS OF THE INVENTION

The use of sputtering in order to deposit coatings on substrates is known in the art. For example, and without limitation, see U.S. Pat. Nos. 5,403,458; 5,317,006; 5,527,439; 5,591,314; 5,262,032; and 5,284,564. Briefly, sputter coating is an electric-discharge-type process which is conducted in a vacuum chamber in the presence of at least one gas (e.g., argon and/oxygen gas). Typically, a sputtering apparatus includes a vacuum chamber, a power source, an anode, and one or more cathode targets (see 1 and 2 in the figures) which include material used to create a coating on an adjacent substrate (e.g., glass substrate or substrate of other material). The sputtering target (1, 2) may include an outer rotatable tube enclosing a magnet bar assembly (5, 6) including and an associated inner magnet bar support tube (3, 4). More specifically, in certain known arrangements, the one or more magnet bar(s) of the magnet bar assembly (5, 6) are secured to the underside of the support tube along substantially the entire length of the support tube. In certain example instances, the magnet bar may also include the support tube. While magnet "bars" 5, 6 are used in many embodiments of this invention, this invention is not so limited and other types of magnets (other than "bars") may instead be used in the magnet assemblies 5, 6 of the targets.

When an electrical potential is applied to the cathode target (1, 2), the gas forms a plasma that bombards the sputtering target, thereby causing particles of the sputtering material from the target to leave the exterior surface of the target. These particles fall onto the substrate (e.g., glass substrate) to form a coating thereon. The outer target tube typically rotates about the stationary magnets which are supported by the inner support tube so that particles are "sputtered" substantially uniformly from the substantially the entire periphery of the target tube as it rotates past the fixed magnet bar(s).

Co-sputtering of materials is an alternative to complex alloying of metallic materials in a single sputtering target. Dual C-MAG rotatable cylindrical magnetron sputtering targets can accomplish the co-sputtering of materials, e.g., by using two sputtering targets placed in relative proximity to one another in the apparatus (e.g., within a common chamber of the sputtering apparatus). The two target tubes may rotate through the plasma, which is substantially confined by the stationary magnet assemblies located inside of the target tubes. Two independently operated power supplies may be used in connection with a dual C-MAG apparatus for co-sputtering. The required ratio of materials may be adjusted by applying different power levels to the cathodes, and by applying appropriate shielding.

Conventional co-sputtering using adjacent sputtering targets aligned in the same manner to sputter downward onto the substrate may result in a significantly graded layer with a strongly varying composition from the bottom to the top of the layer, rather than a true or substantial mixture. It has surprisingly been found that existing dual C-MAG cathodes and cathode arrangements can be modified to produce a much-improved sputter-deposited layer(s) that comprises a better and/or more uniform mixture of the different components.

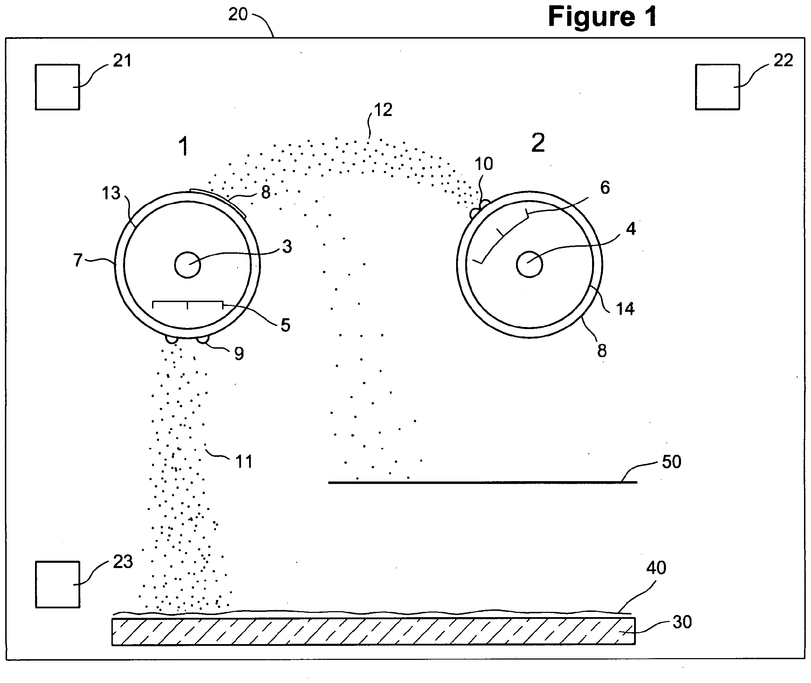

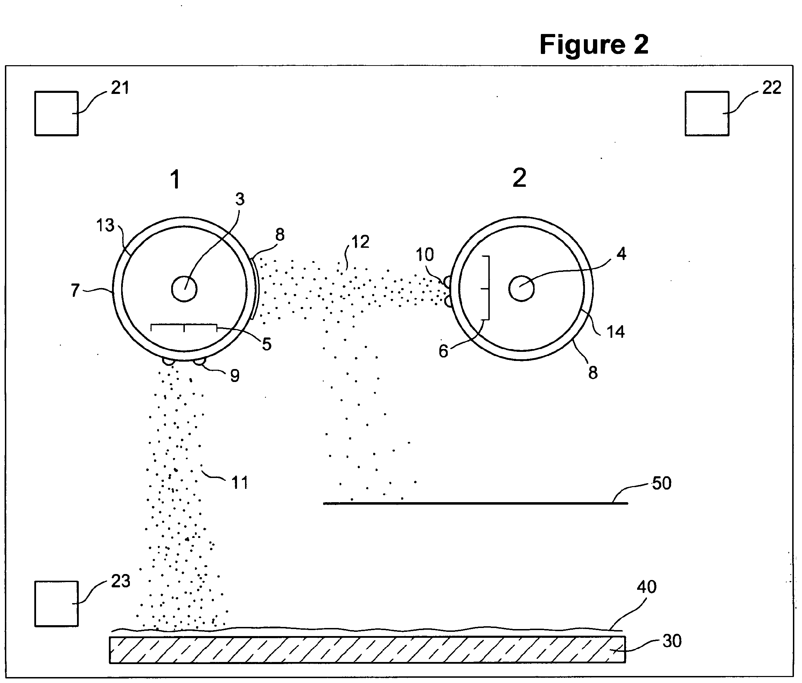

By modifying the position of at least one of the magnet bars (e.g., 6) in at least one of the two rotatable sputtering targets, a film 40 comprising material(s) from both targets (1 and 2) that is a more uniform mixture of composition can be formed. More particularly, in certain example embodiments of this invention, at least two rotatable sputtering targets (1, 2) are provided in a dual C-MAG apparatus. The magnet bar(s) 6 in the second target 2 may be moved from its conventional position to an angled position (e.g., directed toward the first target; e.g., see FIGS. 1 and 2) thereby moving the plasma erosion zone 10 on the second target for example to a location on the side of the second target substantially facing or directed toward or near the first target 1. In such a manner, the second target 2 can be arranged to sputter a substantial portion (e.g., at least about 20%, more preferably at least about 30%, even more preferably at least about 40%, even more preferably at least about 50%, and possibly at least about 60%) of the target material 8 that is sputtered therefrom at and/or onto the first target 1, rather than directly onto the substrate 30. As the first target 1 rotates, the target material 8 from the second target 2 will build up (e.g., substantially uniformly or otherwise) on the first target 1, along with the first target's own target material 7. It is noted that either of the first or second target can be the modified target in different example embodiments, and in some further embodiments, both targets may be modified. Example sputtering materials 7 of
the first target include materials such as one or more of zinc, tin, silicon, titanium, zirconium, nickel, chromium, and the like. Example sputtering materials of the second target 8 include materials such as one or more of zinc, tin, silicon, titanium, zirconium, nickel, chromium, and the like. For example, a first example would be the sputtering material of the first target comprising zinc, and the sputtering material of the second target comprising tin. Another example would be the sputtering material of the first target comprising silicon, and the sputtering material of the second target comprising one or more of zirconium, aluminum, or the like. Another example would be the sputtering material of the first target comprising one or more of silicon and zirconium, and the sputtering material of the second target comprising zirconium. These target materials are provided for purposes of example. In certain example embodiments, the first target, now coated with both its original target material and target material sputtered onto it from the second target, will in turn sputter deposit the target materials from both targets onto a substrate (e.g., glass substrate) to form a thin sputter-deposited film comprising a substantially uniform mixture of at least two different materials. Therefore, the mixed target materials sputtered from the first target will form a more thoroughly mixed film 40 as they are deposited on the glass substrate.

In certain example embodiments of the invention, a first target 1 that comprises target materials 7, 8 from a first and second target will sputter a substantially uniformly mixed film 40 onto a substrate 30. This is surprisingly advantageous because it may reduce the need for an expensive pre-mixed target, and the current dual C-MAG target set up may be modified (in certain example embodiments by moving the position of one of the magnet bar(s)) without any significant need to significantly change many other conditions or aspects of the targets. Moreover, the film formed from co-sputtering in this manner will have a substantially uniform composition in certain example embodiments, because the
target materials will form a film comprising a more evenly distributed mixture of the target materials from both targets.

Another example advantage is that the ratio of target materials in the film's composition can be altered simply by changing the position of one or more of the magnet bars in certain example embodiments. In changing the position of at least one of the magnet bars in a target, its plasma erosion zone can be moved, and for example the second target can be directed to sputter either directly or indirectly toward and/or onto the first target. In certain example embodiments at least second and third sputtering targets may have their magnet bar(s) positions modified so as to sputter material therefrom onto the first target.

Different magnetic field strengths are applied to each of the targets respectively. Using a stronger magnetic field on the second (modified) target 2 may restrict the plasma erosion zone 10 of the second target 2 to a narrower region, thus avoiding excessive material losses on the sputtering chamber's walls or onto the substrate directly. This arrangement may alsoallow a shorter distance between the two targets 1 and 2. This may reduce the amount of material 8 from the second target 2 that is sputtered directly onto the substrate 30, and therefore may increase the amount of material from the second target 2 that is sputtered onto the first target 1 before being sputtered from the first target onto the substrate 30 either directly or indirectly.

In certain example embodiments, it has surprisingly been found that through rotation or movement of at least one of the magnet bars (e.g., 6) of at least one of the targets, a target can be altered to deposit a substantial portion (e.g., at least about 20%, more preferably at least about 30%, even more preferably at least about 40%, even more preferably at least about 50%, and most preferably at least
about 60%) of its target material at and/or onto the first target-rather than directly onto the substrate. Then the first target with materials from both targets on it, can sputter deposit the materials onto the glass substrate to form a film, coating, or layer with a substantially uniform composition. The above descriptions of example embodiments of in this invention apply to both the FIG. 1 and FIG. 2 embodiments. In certain example embodiments, the first and second rotating sputtering targets 1 and 2 are adjacent each other, so that no other sputtering targets are provided therebetween. The materials from the target(s) may be sputter-deposited either directly or indirectly onto the substrate 30 to form the film 40, so that other layer(s) may be on the substrate 30 under the film 40.

FIG. 1 shows an example first embodiment of this invention. In this embodiment, the ratio in the resulting sputter-deposited film 40 of the target material from first target 1 (target material 7) to the material from second target 2 (target material 8) can be high if desired. The film 40 may be substantially transparent, and may be dielectric of conductive in different example embodiments. More specifically, FIG. 1 pertains to an embodiment where it may be desirable that there be more of material 7 than material 8 in the film 40 that is being formed on the substrate (e.g., glass substrate) 30. It has been found that by moving the magnet bar(s) and/or magnet bar assembly 6 in second target 2, the plasma erosion zone 10 of second target 2 can be moved so that it faces or is directed substantially toward the first target 1 as shown in FIG. 1. Rather than the plasma erosion zone 10 being directed toward the substrate 30, it is directed generally toward target 1 as shown in FIG. 1. In particular, the plasma erosion zone 10 of the second target, from which the target material from the second target 2 is sputtered, is directed so that when material therefrom is sputtered a substantial portion of it is directed toward and/or onto the first target 1. In certain example embodiments, it may be directed at least partially toward an upper or upper/right
side of target 1 that is farthest from the substrate as shown in FIG. 1. Alternatively, it may be directed toward other portion(s) of the first target 1 such as the upper/left side or target 1 or the right or left side of target 1. By moving magnet bar or magnet bar assembly 6 so that it is angled in a direction generally toward the first target 1 as shown in FIG. 1, in order to cause the plasma erosion zone 10 and flux 12 to be directed toward the side of target 1 that is substantially opposite the substrate, flux 12 will take an indirect path toward target 1, and less of flux 12 will make it onto target 1. Accordingly, an embodiment such as this will be advantageous when the concentration of target material 7 is desired to be high, because less target material 8 from the second target (via flux 12) will make it onto target 1 and thus into film 40 on substrate 30. An optional shield 50 may be installed under target 2 in order to protect the substrate 30 from contamination by catching at least some of target material 8 that may fall toward the substrate directly from the second target 2. In this and other embodiments of this invention, one of ordinary skill in the art will recognize that while a substantial portion of the target material 8 from the second target 8 will makes it way onto the substrate 30 indirectly by way of the first target 1, some of the target material 8 from the second target 2 may makes its way directly onto the substrate 30 in film 40 without first attaching to the first target 1. The magnet bar assemblies 5 and 6 in FIG. 1 are each shown as having three substantially parallel magnet bars supported by a supporting member (the magnet bars extend into and out of the page in FIG. 1); however, this invention is not so limited and any suitable number of magnet bars may be provided in each target 1, 2 in different embodiments of this invention.

Thus, FIG. 1 depicts a situation where, rather than depositing all target materials 7, 8 simultaneously onto a substrate 30 directly from both targets 1, 2, some of the target material 8 from the second target 2 is deposited on the back side of the first rotating target 1. Thus, the first target material 7 on the first target 1 is contaminated and/or alloyed with the material 8 from the second target 2. As the materials 7 and 8 that are deposited on the first target 1 reach the plasma eroding zone 9 of the first target 1, which is directed toward and/or faces the substrate 30, a film 40 comprising both materials is sputter-deposited onto the substrate 30. This has surprisingly been found to provide an improved mixture of the two materials 7 and 8 in the film 40 compared to the conventional case when all materials from the respective targets are deposited directly onto the substrate.

In certain example embodiments, e.g., when the desired ratio of material 7 to material 8 in the final film 40 is desired to be high, the position of magnet bar(s) 6 of target 2 may form a substantially obtuse angle with the position of magnet bar(s) 5 of target 1. In certain example embodiments, magnet bar 5 may be facing substantially toward the substrate 30, while magnet bar(s) 6 is facing substantially toward target 1 as shown in FIGS. 1-2. If an axis were extended from the sides of magnet bar 6 to intersect an axis extending from the sides of magnet bar 5, it would form an angle that is greater than 90 degrees. In certain example embodiments, the plasma erosion zone 9 of the first target faces substantially toward the substrate 30, whereas the plasma erosion zone 10 of the second target 2 faces substantially toward the first target 1.

Referring to FIG. 1 for example, when viewing the targets cross-sectionally as shown in FIG. 1, the magnet bars of the targets are oriented so that the plasma erosion zone 9 of the first target (where the material is sputtered from) may be arranged to face a first direction which is substantially toward the substrate 30, or toward the substrate plus/minus about 20 degrees more preferably toward the substrate 30 plus/minus about 10 degrees; and the plasma erosion zone 10 of the second target 2 may be arranged to face a direction angled from about 70-170 degrees, more preferably from about 90-150 degrees, and most preferably from
about 90-140 degrees, from the first direction. In certain example embodiments, an optional shielding bar or plate 50 may be installed underneath target 2 to catch at least some target material 8 from target 2 that falls toward the substrate before making it to target 1.

The arrangement is particularly advantageous because it can be obtained simply by rotating the magnetic arrangement (the magnetic bar assembly 6) of target 2, which substantially confines the plasma erosion zone 10 to a position which ejects the material generally toward the first target 1. The magnet bar assembly 6 of the modified target may be rotated anywhere from just above o to about 180 degrees, depending on the ratio of target materials desired in the film. In the FIG. 1 embodiment, magnet bar 6 may originally be in a position similarly to that depicted for magnet bar 5, and may be rotated clockwise from about 70-170 degrees, more preferably from about 90-150 degrees, and most preferably from about 90-140 degrees, in order to arrive at the arrangement depicted in FIG. 1 in certain example embodiments. When the magnet bar is rotated in such a manner, film 40 will have a higher ratio of target material 7 to target material 8 in its final composition may be achieved. The arrangement shown in FIG. 1 is particularly advantageous in example embodiments wherein the desired ratio of the material 7 (from target 1) to material 8 in film 40 is high, as it allows adjustment of the ratios not only by power differences, but also by adjusting the position of the erosion zone 10 on the second target 2. The arrangement shown in FIG. 1 is possible in existing dual C-MAG sputtering chambers where the tubes are relatively close together.

Therefore, in FIG. 1, it can be seen that by adjusting the position of magnet bar 6 relative to magnet bar 5, a conventional dual C-MAG target with rotating targets can be changed into the dual sputtering assembly according to certain example embodiments of the instant invention. The angle between magnet
bar(s) 5 and magnet bar(s) 6 may be adjusted based on both the desired location of the plasma erosion zone 10, and the desired ratio of material 7 to material 8 in the film 40.

In certain example embodiments, the flux 11 (which will include target materials 7 and 8 falling toward the substrate 30) will have substantially the same ratio of material 7 to material 8 as in the sputter-deposited film 40.

FIG. 2 is a cross-sectional schematic view of another example embodiment. The reference numerals in FIG. 2 represent like parts as described above in connection with FIG. 1. The arrangement shown in FIG. 2 may be used, for example, when a lower or more even ratio of material 7 to material 8 is desired in the film 40. More particularly, when it is desirable for a more equal amount or more of target material 8 (as compared to target material 7) to end up in the final film, the arrangement depicted in FIG. 2 may be used for example.

FIG. 2 shows a more direct deposition of target material 8 (via flux 12) from the second target 2 onto the first target 1. In the FIG. 2 embodiment, the magnet bars of the targets are oriented so that the plasma erosion zone 9 of the first target (where the material is sputtered from) is arranged to face a first direction which is substantially toward the substrate 30 (the first directly is substantially perpendicular to the substrate); and the plasma erosion zone 10 of the second target 2 is arranged to face a direction angled about 90 degrees from the first direction. Because the orientation of magnet bar 6 is substantially perpendicular (perpendicular plus/minus about ten degrees) to the orientation of magnet bar 5 in the FIG. 2 embodiment, and the plasma erosion zone 10 and flux 12 from target 2 are directed substantially directly toward target 1, this results in more of flux 12 and thus more target material 8 from target 2 making it onto target 1. Therefore, the concentration of target material 8 on target 1 will be higher than it would be if the plasma erosion zone were not directed at target 1. Again,
optional shielding bar or plate 50 may be installed to block at least some material 8 from the second target from falling from the second target 2 directly onto the substrate 30. The FIG. 2 embodiment may result in more of material 8 being deposited on glass substrate 30 compared to the figure shown in FIG. 1, and thus, a lower ratio of material 7 to material 8 in film 40 compared to the FIG. 1 embodiment.

In certain example embodiments such as that in FIG. 2, particularly when the desired ratio of material 7 to material 8 in the final coating is lower, the orientation of magnet bar 6 of target 2 is substantially perpendicular to the orientation of magnet bar 5 of target 1. In certain example embodiments, magnet bar 5 may be facing toward the substrate, while magnet bar 6 is substantially perpendicular and is facing target 1.

It has been discovered that positioning the magnet bars 5 and 6 on existing cathodes as discussed herein and as shown in FIGS. 1-2 provides a substantially stable plasma discharge on both tubes when operated even from a single AC power supply. However, a single AC power supply is not required. Two power sources may be used instead. This invention may be applicable to AC sputtering which is preferred, or to DC sputtering in alternative embodiments.

Referring to FIGS. 1-2, different magnetic field strengths are used for target 1 versus target 2. Using a stronger field on target 2 can restrict the plasma erosion zone 10 to a narrower region (compared to that of zone 9) and thus can avoid excessive material losses to the chamber walls. This allows a shorter distance between target 1 and target 2 as the plasma can be coupled more tightly to target 2/tube 4 in the case of a strong magnetic field inside target 2/tube 4.

The methods described herein may be applied to alloys where the two target materials are conductive metals or semiconductors, as well as to situations where one or both of the targets are already made of alloys, to form ternary compounds, or compounds containing more than two elements.

For example and without limitation, to form a nickel chromium titanium alloy as a film 40 (which may or may not be oxided), a nickel chromium alloy target material 8 may be used on tube 3 for the first rotating target, and titanium target material 8 may be used on tube 4 for the second rotating target. Another example could include silver doped with small amounts of titanium, nickel, and/or zirconium to improve durability and stability. These materials are provided for purposes of example only, and are in no way considered to be limiting. The target material(s) 7, 8 may be metal or metal oxides in different example embodiments of this invention.

The arrangements described in FIGS. 1 and 2 may or may not be used in a reactive sputtering process to form multi-compound nitrides and/or oxides. In a reactive sputtering process, a reactive gas (e.g., oxygen and/or nitrogen) can be introduced either above or below the target tubes, at any or all of gas inlets 21, 22, and/or 23, possibly along with an inert gas such as argon, which may allow control of the composition of the resulting film 40 more precisely. In the conventional reactive process with plasma discharge from both tubes directed solely toward the substrate, the reactive gas is consumed substantially entirely in the narrow space between the tubes and the substrate. Whether the gas is fed in through the top or the bottom may only have a small effect on the overall stability. In a normal reactive process, a "hysteresis" effect may be seen, which involves a rapid and self-enhancing transition between a target surface that is fully covered by reaction products at high reactive gas pressures, and a situation where the erosion is strong enough to keep the target clean (metallic) from reactive compounds at low reactive gas pressures. The obtained films may therefore either be rich in the target material (metallic), or contain excess reactive gas. This makes
it very difficult to obtain stoichiometric films in a fully reactive process (e.g., sputtering tin oxide with a metallic tin target).

It has been found that moving the plasma, and thus, the reaction zone of target 2 away from the reaction zone of target 1 as described in certain example embodiments of this invention (see FIGS. 1-2) allows the creation of a steeper reactive gas gradient between the top of the discharge chamber and the actual substrate zone. Moreover, the reaction rate for different materials with nitrogen or oxygen is different and thus the transition on the surface of target 1 happens at a different reactive gas pressure than the transition on target 2. This leads to a more gradual overall transition, which can be further controlled by the ratio and method by which gas is fed into the top (21 and 22) and bottom (23) gas inlets, as well as by the power ratio between the two tubes/targets.

Another example embodiment of this invention involves feeding the reactive gas (e.g., oxygen and/or nitrogen) primarily through the top inlet(s) 21 and/or 22. This leads to a ceramic layer of material 8 being deposited on the surface/outer tube 13 of target 1. Thus, the discharge from target 1 toward the substrate 30 would be very similar to a target that was originally made with ceramic material. In certain example embodiments, this method could be used to deposit conductive oxide films (e.g., ITO or Al-doped ZnO) 40, or alternatively dielectric films 40.

In certain example embodiments, both target materials 7, 8 may be made from a metallic alloy. For example and without limitation, the metallic alloy may comprise indium tin or zinc aluminum. Sputtering target 2, with enough reactive gas from the top gas inlet(s) 21 and/or 22 toward target 1, can create an oxide layer on the outer tube/surface 13 of target 1, which would then be deposited to the substrate 30 as if from a ceramic oxide target. In this case, the bottom gas inlet/feed 23 may be used to balance the remaining oxygen as is generally done in
the case of ceramic targets with small oxygen flows. The deposition of transparent conductors is typically done using expensive ceramic targets, as the deposition from metallic targets is very unstable and difficult to control. Thus, accordingly, in certain example embodiments of this invention, the deposition method may combine the cost advantages of metal targets with the process stability seen from ceramic targets. However, both targets and target materials may also remain metallic, with the oxygen reacting with the target materials only after it has been freed from the target, in other example embodiments of this invention.

The film 40 formed in certain example embodiments of this invention may comprise target materials 7 and 8 in a ratio of from about 99:1 to 50:50 (with 50:50 being 1:1) in certain examples of this invention. In other example embodiments, the film 40 may comprise a ratio of target material 7 to target material 8 of from about 75:25 to 25:75, including all sub-ranges therebetween. The film may further comprise oxygen and/or nitrogen in certain example embodiments. However, this invention is not so limited, and any ratio of target materials desired may be obtained. Moreover, more than two target materials and more than two targets may be used, in any ratio desired, in other example embodiments.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of making a coated article comprising a film supported by a substrate, the method comprising:
having first and second rotating cylindrical sputtering targets, the first sputtering target comprising a first sputtering material and the second sputtering target comprising a second sputtering material,
sputtering the first and second sputtering targets, and wherein at least one magnet bar of the second sputtering target is oriented so that during the sputtering of the second target second sputtering material from the second target is sputtered onto the first target, and during the sputtering of the first target the first sputtering material of the first target and second sputtering material which was sputtered onto the first target from the second target is sputter-deposited onto a substrate to form the film, **characterized in that** a first magnetic field strength is provided for the first target and a second magnetic field strength is provided for the second target, and wherein the second magnetic field strength is stronger than the first magnetic field strength.

2. The method of claim 1, comprising sputtering the first and second sputtering targets when the first and second sputtering targets are located in a sputtering chamber adjacent each other so that no other sputtering targets are located between the first and second sputtering targets.

3. The method of claim 1, comprising sputtering the second target so that a substantial portion of the second sputtering material that is sputtered from the second target is sputtered onto the first target.

4. The method of claim 1, comprising sputtering the second target so that at least 30% of the second sputtering material that is sputtered from the second target is sputtered onto the first target.

5. The method of claim 1, comprising sputtering the second target so that at least 40% of the second sputtering material that is sputtered from the second target is sputtered onto the first target.

6. The method of claim 1, further comprising orienting magnets of the first and second targets so that a plasma erosion zone of the first target is generally oriented to face a first direction which is toward the substrate, and a plasma erosion zone of the second target is generally oriented to face a second direction that is angled from 70-170 degrees from the first direction.

7. The method of claim 1, further comprising orienting magnets of the first and second targets so that a plasma erosion zone of the first target is generally oriented to face a first direction which is toward the substrate, and a plasma erosion zone of the second target is generally oriented to face a second direction that is angled from 90-150 degrees from the first direction.

8. The method of claim 1, further comprising orienting a magnet bar assembly of the first target and a magnet bar assembly of the second target so that they are perpendicular to each other.

9. The method of claim 1, wherein a plasma erosion zone of the second target faces the first target, and a plasma erosion zone of the first target faces the substrate.

10. The method of claim 1, further comprising feeding a reactive gas comprising oxygen primarily from a top gas inlet of a sputtering chamber in which the targets are located, and wherein sputtering the second sputtering material from the second target onto the first target forms a ceramic layer comprising the second sputtering material on the first target.

11. The method of claim 1, wherein the film comprises equal amounts of first and second target materials.

12. The method of claim 1, wherein the thin film comprises more of the first target material than the second target material.

## Patentansprüche

1. Verfahren zum Herstellen eines beschichteten Artikels, der eine Schicht aufweist, die von einem Substrat getragen wird, wobei das Verfahren aufweist:
Aufweisen eines ersten und eines zweiten rotierenden zylindrischen Sputtertargets, wobei das erste Sputtertarget ein erstes Sputtermaterial aufweist und das zweite Sputtertarget ein zweites Sputtermaterial aufweist;
Sputtern des ersten und des zweiten Sputtertargets, und wobei zumindest eine Magnetstange des zweiten Sputtertargets so ausgerichtet ist, dass während des Sputterns des zweiten Targets zweites Sputtermaterial von dem zweiten Target auf das erste Target gesputtert wird, und das während des Sputterns des ersten Targets das erste Sputtermaterial des ersten Targets und zweites Sputtermaterial, welches auf das erste Target von dem zweiten Target gesputtert wurde, auf einem Substrat sputter-abgelagert wird, um die Schicht zu bilden, **dadurch gekennzeichnet, dass**
eine erste magnetische Feldstärke für das erste Target bereitgestellt wird, und eine zweite magnetische Feldstärke für das zweite Target bereitgestellt wird, und wobei die zweite magnetische Feldstärke stärker ist, als die erste magnetische Feldstärke.

2. Verfahren nach Anspruch 1, aufweisend Sputtern des ersten und des zweiten Sputtertargets, wenn das erste und das zweite Sputtertarget in einer Sputterkammer benachbart zueinander angeordnet sind, so dass keine anderen Sputtertargets zwischen dem ersten und dem zweiten Sputtertarget angeordnet sind.

3. Verfahren nach Anspruch 1, aufweisend Sputtern des zweiten Targets, so dass ein wesentlicher Teil des zweiten Sputtermaterials, welches von dem zweiten Target gesputtert wird, auf das erste Target gesputtert wird.

4. Verfahren nach Anspruch 1, aufweisend Sputtern des zweiten Targets, so dass zumindest 30% des zweiten Sputtermaterials, welches von dem zweiten Target gesputtert wird, auf das erste Target gesputtert wird.

5. Verfahren nach Anspruch 1, aufweisend Sputtern des zweiten Targets, so dass zumindest 40% des zweiten Sputtermaterials, welches von dem zweiten Target gesputtert wird, auf das erste Target gesputtert wird.

6. Verfahren nach Anspruch 1, weiterhin aufweisend ein Ausrichten von Magneten des ersten und des zweiten Targets, so dass eine Plasmaerosionszone des ersten Targets hauptsächlich in einer ersten Richtung ausgerichtet ist, welche hin zu dem Substrat gerichtet ist, und eine Plasmaerosionszone des zweiten Targets hauptsächlich in eine zweite Richtung ausgerichtet ist, die in einem Winkel von 70 - 170 Grad zur ersten Richtung liegt.

7. Verfahren nach Anspruch 1, weiterhin aufweisend ein Ausrichten von Magneten des ersten und des zweiten Targets, so dass eine Plasmaerosionszone des ersten Targets hauptsächlich in einer ersten Richtung ausgerichtet ist, welche hin zu dem Substrat gerichtet ist, und eine Plasmaerosionszone des zweiten Targets hauptsächlich in eine zweite Richtung ausgerichtet ist, die in einem Winkel von 90 - 150 Grad zur ersten Richtung liegt.

8. Verfahren nach Anspruch 1, weiterhin aufweisend ein Ausrichten einer Magnetstangenanordnung des ersten Targets und einer Magnetstangenanordnung des zweiten Targets, so dass diese rechtwinklig zueinander sind.

9. Verfahren nach Anspruch 1, wobei eine Plasmaerosionszone des zweiten Targets auf das erste Target gerichtet ist, und eine Plasmaerosionszone des ersten Targets auf das Substrat gerichtet ist.

10. Verfahren nach Anspruch 1, weiterhin aufweisend das Einführen eines reaktiven Gases, welches Sauerstoff aufweist, vorzugsweise aus einem oberen Gaseinlass einer Sputterkammer, in welcher die Targets angeordnet sind, und wobei das Sputtern des zweiten Sputtermaterials von dem zweiten Target auf das erste Target eine keramische Schicht bildet, die das zweite Sputtermaterial auf dem ersten Target aufweist.

11. Verfahren nach Anspruch 1, wobei die Schicht gleiche Anteile des ersten und des zweiten Targetmaterials aufweist.

12. Verfahren nach Anspruch 1, wobei die Dünnschicht mehr von dem ersten Targetmaterial als von dem zweiten Targetmaterial aufweist.

## Revendications

1. Procédé de fabrication d'un article revêtu comprenant un film supporté par un substrat, le procédé comprenant :
la mise à disposition d'une première et d'une deuxième cible de pulvérisation cathodique cylindriques rotatives, la première cible de pulvérisation cathodique comprenant un premier matériau de pulvérisation et la deuxième cible de pulvérisation cathodique comprenant un deuxième matériau de pulvérisation,
la pulvérisation de la première et de la deuxième cible de pulvérisation cathodique, au moins un barreau aimanté de la deuxième cible de pulvérisation cathodique étant orienté de telle sorte que, pendant la pulvérisation de la deuxième cible, le deuxième matériau de pulvérisation provenant de la deuxième cible soit pulvérisé sur la première cible et que, pendant la pulvérisation de la première cible, le premier matériau de pulvérisation de la première cible et le deuxième matériau de pulvérisation qui a été pulvérisé sur la première cible à partir de la deuxième cible soient déposés par pulvérisation sur un substrat pour former le film, **caractérisé en ce qu'**une première intensité de champ magnétique est appliquée à la première cible et une deuxième intensité de champ magnétique est appliquée à la deuxième cible, la deuxième intensité de champ magnétique étant plus importante que la première intensité de champ magnétique.

2. Procédé selon la revendication 1, comprenant la pulvérisation de la première et de la deuxième cible de pulvérisation cathodique quand la première et la deuxième cible de pulvérisation cathodique sont situées dans des chambres de pulvérisation adjacentes l'une à l'autre de telle sorte qu'aucune autre cible de pulvérisation cathodique ne soit située entre la première et la deuxième cible de pulvérisation cathodique.

3. Procédé selon la revendication 1, comprenant la pulvérisation de la deuxième cible de telle sorte qu'une partie importante du deuxième matériau de pulvérisation qui est pulvérisé à partir de la deuxième cible soit pulvérisée sur la première cible.

4. Procédé selon la revendication 1, comprenant la pulvérisation de la deuxième cible de telle sorte qu'au moins 30 % du deuxième matériau de pulvérisation qui est pulvérisé à partir de la deuxième cible soit pulvérisé sur la première cible.

5. Procédé selon la revendication 1, comprenant la pulvérisation de la deuxième cible de telle sorte qu'au moins 40 % du deuxième matériau de pulvérisation qui est pulvérisé à partir de la deuxième cible soit pulvérisé sur la première cible.

6. Procédé selon la revendication 1, comprenant en outre l'orientation d'aimants de la première et de la deuxième cible de telle sorte qu'une zone d'érosion par plasma de la première cible soit d'une manière générale orientée dans une première direction qui est dirigée vers le substrat, et qu'une zone d'érosion par plasma de la deuxième cible soit d'une manière générale orientée dans une deuxième direction qui fait un angle de 70 à 170 degrés avec la première direction.

7. Procédé selon la revendication 1, comprenant en outre l'orientation d'aimants de la première et de la deuxième cible de telle sorte qu'une zone d'érosion par plasma de la première cible soit d'une manière générale orientée dans une première direction qui est dirigée vers le substrat, et qu'une zone d'érosion par plasma de la deuxième cible soit d'une manière générale orientée dans une deuxième direction qui fait un angle de 90 à 150 degrés avec la première direction.

8. Procédé selon la revendication 1, comprenant en outre l'orientation d'un ensemble à barreau aimanté de la première cible et d'un ensemble à barreau aimanté de la deuxième cible de façon qu'ils soient perpendiculaires l'un à l'autre.

9. Procédé selon la revendication 1, dans lequel une zone d'érosion par plasma de la deuxième cible est en regard de la première cible, et une zone d'érosion par plasma de la première cible est en regard du substrat.

10. Procédé selon la revendication 1, comprenant en outre l'introduction d'un gaz réactif comprenant principalement de l'oxygène à partir d'une entrée de gaz en tête d'une chambre de pulvérisation dans laquelle sont situées les cibles, et dans lequel la pulvérisation du deuxième matériau de pulvérisation à partir de la deuxième cible sur la première cible forme une couche céramique comprenant le deuxième matériau de pulvérisation sur la première cible.

11. Procédé selon la revendication 1, dans lequel la couche comprend des quantités égales du premier et du deuxième matériau de cible.

12. Procédé selon la revendication 1, dans lequel la couche mince comprend une quantité du premier matériau de cible plus importante que celle du deuxième matériau de cible.
